# EUROPÄISCHE PATENTANMELDUNG

(11) **EP 2 151 870 A2**
(43) Veröffentlichungstag der Anmeldung: **10.02.2010**
(21) Anmeldenummer: 09010078.5
(22) Anmeldetag: 04.08.2009
(51) Int. Cl.: H01L 31/0224, H01L 31/0392, H01L 27/144

(54) **Verfahren zur Herstellung eines photovoltaischen Moduls**

(30) Priorität: 07.08.2008 DE 102008036853
(71) Anmelder: SCHOTT Solar AG, 55122 Mainz (DE)
(72) Erfinder: Lechner, Peter, 85591 Vaterstetten (DE); Psyk, Walter, 81371 München (DE); Maurus, Hermann, 85540 Haar (DE)
(74) Vertreter: Haft, von Puttkamer, Berngruber, Karakatsanis

(57) **Zusammenfassung**

Zur Herstellung eines photovoltaischen Moduls (1) werden auf ein transparentes Substrat (2) eine transparente Frontelektrodenschicht (3), eine Halbleiterschicht (4) und eine Rückelektrodenschicht (5) aufgebracht, welche zur Bildung serienverschalteter Zellen (C₁, C₂, ... Cₙ, Cₙ₊₁) durch Trennlinien (6, 7, 8) strukturiert werden. Nach Aufbringen der Halbleiterschicht (4) wird auf die Bereiche der Halbleiterschicht (4), an denen die Trennlinien (8) in der Rückelektrodenschicht (5) gebildet werden sollen, eine wasserlösliche Ablösemasse (12) mit einem Tintenstrahldrucker (15) aufgetragen, worauf die Rückelektrodenschicht (5) aufgebracht wird. Die Ablösemasse (12) wird mit den darauf aufgebrachten Bereichen der Rückelektrodenschicht (5) unter Bildung der Trennlinien (8) in der Rückelektrodenschicht (5) mit einem Wasserstrahl (13) entfernt.

## Beschreibung

Die Erfindung bezieht sich auf ein Verfahren zur Herstellung eines photovoltaischen Moduls nach dem Oberbegriff des Patenanspruchs 1.

Bei der Herstellung eines photovoltaischen Moduls werden auf einem transparenten, elektrisch isolierenden Substrat, beispielsweise einer Glasscheibe, drei Funktionsschichten, nämlich eine transparente Frontelektrodenschicht, eine Halbleiterdünnschicht und eine Rückelektrodenschicht großflächig abgeschieden.

Um aus diesen monolithischen Schichten serienverschaltete Zellen zu bilden, werden die Schichten z.B. mit einem Laser, mechanischen Verfahren oder auf chemischem Wege durch Trennlinien strukturiert.

Zur Strukturierung der Frontelektrodenschicht, die beispielsweise aus einem transparenten, elektrisch leitfähigen Metalloxid (TCO), beispielsweise dotiertem Zinnoxid, besteht, wird üblicherweise die Lasertechnik eingesetzt. Der verwendete Laser ist typischerweise ein Neodym dotierter Yttrium-Aluminium-Granat (Nd:YAG)- oder ein Neodym dotierter Yttrium-Vanadat (Nd:YVO₄)-Festkörperlaser, der ein Strahlung mit einer Wellenlänge von 1064 nm emittiert.

Die Strukturierung der Halbleiterschicht, beispielsweise eine Silizium-Dünnschicht, erfolgt ebenfalls typischerweise mit Laserlicht. Dabei wird ein frequenzverdoppelter (Nd:YAG)- oder ein (Nd:YVO₄)-Festkörperlaser verwendet, der ein Laserlicht mit einer Wellenlänge von 532 nm emittiert.

Zur Strukturierung der Rückelektrodenschicht, die aus Metall oder einem elektrisch leitfähigen Metalloxid besteht, werden sowohl mechanische Verfahren wie Laserverfahren eingesetzt.

Bei der Strukturierung der Rückelektrodenschicht mit Lasertechnik wird typischerweise ein (Nd:YAG)- oder ein (Nd:YVO₄)-Festkörperlaser verwendet und der Laserstrahl von der Glasseite in die Schichten fokussiert. Bei den mechanischen Verfahren wird die Maskentechnik eingesetzt, bei der beispielsweise Metalldrähte die Halbleiteroberfläche beim Beschichten mit der Rückelektrodenschicht maskieren oder auf der Halbleiterschicht wird in den Bereichen, an denen die Rückelektrodenschicht mit Trennlinien versehen werden soll, linienförmig eine haftenden Paste aufgebracht, sodass die Halbleiterschicht in diesen Bereichen beim anschließenden Beschichten mit der Rückelektrodenschicht maskiert ist. In den folgenden "Lift-Off"-Prozess wird das linienförmige maskierende Medium mit der darüber liegenden Rückelektrodenschicht mechanisch entfernt. Somit wird die Rückelektrodenschicht in einzelne Streifen separiert.

Während bei der Bildung der Trennlinien in der Rückelektrodenschicht mit der Laser-Technik die darunter liegende Halbleiterschicht mehr oder weniger in Mitleidenschaft gezogen wird, bleibt bei Verwendung einer Paste und dem "Lift-Off"-Prozess die Halbleiterschicht unbeeinträchtigt.

Das Auftragen einer Paste als maskierendes Medium erfolgt mit einem Dosierwerkzeug, mit dem die Paste durch eine Hohlnadel oder dergleichen Düse auf die Halbleiterschicht aufgetragen wird. Synchron zur Bewegung des Werkzeugs wird mit einem Dosiermedium, das im Allgemeinen druckluftgesteuert ist, dem Dosierwerkzeug aus einem Vorratsbehälter die erforderliche Menge an Paste zugeführt.

Die Paste wird auf die Halbleiterschicht in parallelen, äquidistanten Linien aufgetragen. Dazu wird, wenn eine Linie auftragen worden ist, das Auftragen der Paste unterbrochen, bis das Spritzwerkzeug so positioniert worden ist, dass die nächste Linie aufgetragen werden kann. Der zeitlich unterbrochene Pastenauftrag kann zur Folge haben, dass sich die Düse durch Pastenreste zusetzt.

Zudem kann die Hohlnadel durch Austrocknen der Paste verstopfen, wenn nach dem Auftragen aller Linien auf die Halbleiterschicht eines Moduls das Modul entladen wird, um die Paste auf die Halbleiterschicht eines neuen Moduls aufzutragen.

Auch kann beispielsweise bei Schwankungen der Versorgungsmedien, z.B. der Druckluft, das Auftragen der Paste für eine Linie unterbrochen werden. Damit wird ein Bereich der Halbleiterschicht innerhalb einer Linie nicht maskiert. Bei unterbrochenen Pastenlinien ist nach der Beschichtung mit der Rückelektrodenschicht und nach dem "Lift-Off"-Prozess die Rückelektrodenschicht benachbarter Zellen des photovoltaischen Moduls elektrisch verbunden und somit die Zellen elektrisch kurzgeschlossen.

Dies führt zu einem erheblich Ausschuss. Zudem muss für ein fehlerfreies Funktionieren des Pastenauftrags eine aufwändige Prozesskontrolle und intensive Wartung der Pastenauftragwerkzeuge durchgeführt werden.

Aufgrund ihrer zähen Konsistenz werden mit der Paste Linien mit einer Dicke von etwa 500 nm auf der Halbleiterschicht gebildet. Die Linien müssen vor dem Beschichten mit der Rückelektrodenschicht z.B. durch Sputtern getrocknet werden. Das Trocknen der dicken Linien nimmt jedoch viel Zeit in Anspruch. Wird die Paste nicht ausreichend getrocknet, besteht die Gefahr, dass sie während der Beschichtung mit dem Rückkontakt, z.B. durch Glimmentladungsabscheidung (PE-PVD) im Vakuum, auseinander läuft und damit nach dem "Lift-Off"-Prozess ein photovoltaisches Modul mit Trennlinien undefinierter Breite in der Rückelektrodenschicht erzeugt wird.

Aufgabe der Erfindung ist es daher, photovoltaische Module hoher Qualität ohne Ausschussprobleme mit einem geringeren Aufwand herzustellen.

Dies wird erfindungsgemäß mit dem im Anspruch 1 gekennzeichneten Verfahren erreicht. In den Unteransprüchen sind bevorzugte Ausgestaltungen des erfindungsgemäßen Verfahrens wiedergegeben.

Nach dem erfindungsgemäßen Verfahren wird das transparente, elektrisch nicht leitfähige Substrat, beispielsweise eine Glasscheibe oder Kunststoffplatte, zunächst mit der transparenten Frontelektrodenschicht beschichtet. Die Beschichtung mit der transparenten Frontelektrodenschicht kann beispielsweise durch PE-PVD erfolgen. Die Frontelektrodenschicht besteht vorzugsweise aus TCO (Transparent Conductive Oxide), z.B. dotiertes, insbesondere Fluor dotiertes Zinnoxid, dotiertes, insbesondere Aluminium dotiertes Zinkoxid oder dergleichen.

Anschließend werden zur Strukturierung der Frontelektrodenschicht die Trennlinien beispielsweise mit einem Laser, vorzugsweise mit einem (Nd:YAG)- oder ein (Nd:YVO₄)-Festkörperlaser mit einer Wellenlänge von 1064 nm erzeugt.

Die strukturierte Frontelektrodenschicht wird dann mit der Halbleiterschicht beschichtet, beispielsweise durch PECVD. Die Halbleiterschicht kann aus Silizium, beispielsweise amorphem, nano-, mikro- oder polykristallinem Silizium bestehen, aber auch aus anderen Halbleitern, beispielsweise Kupfer-Indium- oder Kupfer-Indium-Gallium-Sulfid und/oder - Selenid oder aus Cadniumtellurid. Die Trennlinien in der Frontelektrodenschicht werden beim Beschichten mit der Halbleiterschicht mit dem Halbleiter verfüllt.

Zur Strukturierung der Halbleiter-Dünnschicht werden beispielsweise mit einem Laser, vorzugsweise einem (Nd:YAG)- oder (Nd:YVO₄)-Festkörperlaser mit einer Wellenlänge von 532 nm die Trennlinien in der Halbleiterschicht erzeugt.

Anschließend werden die Bereiche der Halbleiterschicht, an denen die Trennlinien in der Rückelektrodenschicht gebildet werden sollen, mit einer Ablösemasse versehen.

Zur Bildung der Ablösemasse wird erfindungsgemäß eine Dispersion oder Lösung der Ablösemasse verwendet, die mit einem Tintenstrahldrucker auf die Halbleiterschicht aufgetragen und anschließend getrocknet wird.

Die Ablösemasse kann beispielsweise aus einem Bindemittel bestehen, das Pigmente oder Farbstoffe enthalten kann. Vorzugsweise werden Harze, insbesondere wasserlösliche Harze als Bindemittel verwendet, beispielsweise Kunststoffharze, die Carboxyl-, Hydroxyl- oder dergleichen salzbildende Gruppen enthalten, z.B. carboxylgruppenhaltige Harnstoff- und/oder Aldehydharze. Das Löse- oder Dispersionsmittel, in dem das Bindemittel gelöst oder dispergiert ist, kann beispielsweise ein Alkohol oder ein anderes leichtflüchtiges, vorzugsweise mit Wasser mischbares Lösungsmittel sein. Beispielsweise können zur Bildung der Ablösemasse auch wasserlösliche Tinten verwendet werden, die im Handel zum Bedrucken von Stahl mit Tintenstrahldruckern angeboten werden.

Die wesentliche Eigenschaft der erfindungsgemäßen verwendeten Lösung bzw. Dispersion, die mit dem Tintenstrahldrucker aufgetragen wird, um die Ablösemasse zu bilden, ist schnell zu trocknen und einen dünnen Film zu bilden, der nach dem Trocknen nicht dicker als die Rückelektrodenschicht sein soll, also vorzugsweise eine Schichtdicke von 0,1 bis 5 µm, insbesondere 0,3 bis 3 µm, aufweist.

Da die Rückelektrodenschicht im Allgemeinen im Vakuum, z.B. durch Sputtern aufgetragen wird, sollte die Ablösemasse im trockenen Zustand vakuumbeständig sein, und hohen Temperaturen widerstehen. Ferner muss die Ablösemasse nach der Beschichtung mit der Rückelektrodenschicht, der anschließenden Belüftung auf Atmosphärendruck und Abkühlung auf Raumtemperatur an der Halbleiterschicht gut haften. Außerdem darf die Ablösemasse nach dem Trocknen keine Risse bilden, da diese, wenn sie beim Beschichten mit der Rückelektrodenschicht verfüllt werden, zu einem Kurzschluss zwischen benachbarten Zellen des photovoltaischen Moduls führen würden.

Als Tintenstrahldrucker wird vorzugsweise ein kontinuierlicher oder so genannter Continuous-Ink-Jet oder CIJ-Drucker oder ein Drop-on-Demand- oder DOD-Drucker verwendet. Ein kontinuierlicher Tintenstrahldrucker oder CIJ-Drucker wird bevorzugt. Bei ihm tritt die Ablösemasse-Lösung bzw. -Dispersion auch in der Pause aus der Düse aus, wenn nach dem Auftragen aller Linien auf die Halbleiterschicht ein Modul entladen wird, um die Halbleiterschicht eines neuen Moduls mit den Ablösemasselinien zu versehen. Dabei wird die aus der Düse in der Pause austretende Ablösemasse-Lösung bzw. - Dispersion in einem Gefäß aufgefangen und im Kreislauf zu dem Vorratsbehälter des Tintenstrahldruckers zurückgeführt. Damit ist verhindert, dass sich die Düse des Tintenstrahldruckers beim Be- und Entladen der Module zusetzt. D.h. bei einem kontinuierlichen Tintenstrahldrucker ist die Ablösemasse-Lösung bzw. - Dispersion in der Düse ständig in Bewegung, sodass sie nicht verklumpen oder Austrocknen kann.

Bei dem vorzugsweise kontinuierlichen Tintenstrahldrucker tritt der Strahl durch eine piezoelektrischen Wandler in einzelnen Tropfen aus der Düse aus, die mit Ladeelektroden elektrostatisch aufgeladen und mit Ablenkelektroden seitlich abgelenkt werden können, also entweder zur Linienbildung auf die Halbleiterschicht des jeweiligen Moduls oder in den Auffangbehälter zur Rückführung der Ablösemasse-Lösung bzw. Dispersion.

Die mit dem Tintenstrahldrucker in Tröpfchen aufgebrachte Ablösemasse weist je nach relativer Geschwindigkeit zwischen dem Tintenstrahldrucker und dem mit der Frontelektroden- und Halbleiterschicht versehenen Substrat sowie der Größe der vom Tintenstrahldrucker abgegebenen Tropfen gerade oder durch Aneinanderreihung diskreter Tropfen bogenförmig gewölbte Ränder auf. Dabei sollte die Breitenschwankung der aufgetragenen Ablösemasselinie nach dem Trocknen nicht mehr als 20 bis 30 % betragen. Die Breite der Ablösemasselinien kann z. B. 50 bis 500 µm, insbesondere 100 bis 300 µm betragen.

Beim Auftragen der Ablösemasse werden der Tintenstrahldrucker und das mit der Frontelektroden- und Halbleiterschicht versehene Substrat relativ zueinander bewegt. Dazu kann das Substrat beispielsweise auf einem Schlitten angeordnet sein, der in einer oder zwei zueinander senkrechten Richtungen bewegbar ist und/oder der Tintenstrahldrucker kann an einem Träger, der in einer zu der Bewegungsrichtung des Schlittens senkrechten Richtung bewegbar ist, vorgesehen sein. Auch kann das Substrat auf einem Tisch angeordnet sein, wobei der Träger gegenüber dem Tisch in zwei zueinander senkrechten Richtungen oder wenn der Tintenstrahldrucker entlang dem Träger bewegbar ist, nur in einer Richtung bewegbar ist.

Nach dem die Halbleiterschicht des Moduls mit den Ablösemasselinien versehen worden ist, wird die Rückelektrodenschicht aufgetragen.

Die Rückelektrodenschicht wird vorzugsweise durch eine Metallschicht oder ein elektrisch leitendes Metalloxid gebildet. Die Metallschicht kann beispielsweise aus Aluminium, Kupfer oder Silber bestehen. Das Metalloxid kann ein transparentes Metalloxid sein, beispielsweise Zinnoxid oder Zinkoxid.

Auch kann zwischen der Metallschicht und der Halbleiterschicht eine Zwischenschicht aufgebracht werden, die beispielsweise aus einem dotierten TCO, wie Indiumoxid oder Aluminium dotiertem Zinkoxid besteht und z.B. verhindert, dass Metallatome aus der Metallschicht in die Halbleiterschicht des Moduls diffundieren.

Die Rückelektrodenschicht wird vorzugsweise durch Sputtern aufgebracht, kann jedoch auch durch andere Beschichtungsverfahren aufgetragen werden, beispielsweise durch Bedampfung. Dabei werden die Trennlinien oder Gräben in der Halbleiterschicht verfüllt.

Nach dem Beschichten der mit der Ablösemasse-Linien versehenen Halbleiterschicht mit der Rückelektrodenschicht wird die Ablösemasse mit der darauf aufgebrachten Rückelektrodenschicht mechanisch entfernt ("Lift-Off"-Prozess).

Dazu wird vorzugsweise ein Wasserstrahl verwendet, um die vorzugsweise wasserlösliche Ablösemasse zu entfernen. Mit dem Wasserstrahl wir die Ablösemasse rückstandsfrei aufgelöst und die darauf liegende Rückelektrodenschicht löst sich in diesem Bereich ab. Der Druck des Wasserstrahls kann beispielsweise 0,5 bis 2 bar betragen.

Um ein rückstandsfreies Ablösen der auf der Ablösemasse aufgebrachten Rückelektrodenschicht beim "Lift-Off"-Prozess zu garantieren, ist eine gute Benetzung der Halbleiterschicht notwendig. Durch die Benetzung der Halbleiterschicht durch die Ablösemasse-Lösung bzw. Dispersion wird zugleich ein fehlerfreies Bild, also kein Einschnüren oder Verlaufen der Lösung bzw. Dispersion erhalten und damit eine Trennlinie gebildet, bei der ein eventueller elektrischer Kurzschluss benachbarter Zellen des Moduls durch eine Brücke in der Rückelektrodenschicht verhindert ist.

Durch die Verwendung von (neutralem) Wasser für den "Lift-Off"-Prozess ist sicher gestellt, dass die Halbleiterschicht dabei nicht beeinträchtigt wird.

Damit ist die Rückelektrodenschicht ebenfalls mit den erforderlichen Trennlinien versehen und die Strukturierung zur Bildung serienverschalteter Zellen des photovoltaischen Moduls abgeschlossen.

Die Trennlinien in der Rückelektrodenschicht können eine Breite von beispielsweise von 50 bis 300 µm aufweisen, um die für die integrierte Serienverschaltung notwendige elektrische Trennung der Zellen des photovoltaischen Moduls zu erzielen. Die Breite der Trennlinien in der Frontelektrodenschicht und in der Halbleiterschicht beträgt typischerweise 30 bis 50 µm.

Mit der Erfindung wird eine hohe Prozesssicherheit und - stabilität erreicht. Auch sind keine aufwändige Wartungs- und Kontrollarbeiten notwendig.

Nachstehend ist die Erfindung anhand der Zeichnung beispielhaft näher erläutert. Darin zeigen jeweils schematisch:
Figur 1 einen Querschnitt durch ein photovoltaisches Modul;
Figur 2a und 2b jeweils perspektivisch eine teilweise Ansicht zweier benachbarter Zellen nach dem Beschichten des Moduls mit der Rückelektrodenschicht bzw. nach dem "Lift-Off"-Prozess; und
Figur 3 und 4 eine Seitenansicht bzw. verkleinerte Draufsicht einer Vorrichtung zum Auftragen der Ablösemasse auf das mit der Frontelektrodenschicht und der Halbleiterschicht versehene Substrat.

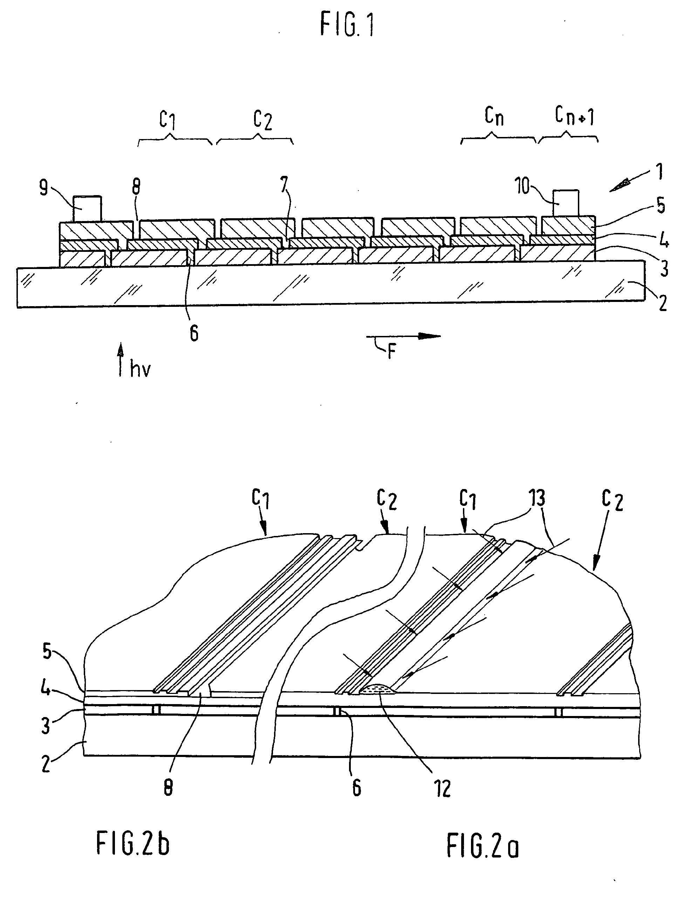

Gemäß Figur 1 weist das photovoltaische Dünnschichtmodul 1 ein transparentes Substrat 2, beispielsweise eine Glasscheibe, auf, die an der Lichteinfallsseite hv des Moduls angeordnet ist. Auf dem Substrat 2 sind drei Funktionsschichten, nämlich eine transparente Frontelektrodenschicht 3, eine Halbleiterdünnschicht 4, und eine Rückelektrodenschicht 5 aufeinander abgeschieden. Die Rückelektrodenschicht 5 kann mit einer nicht dargestellten Schutzschicht z.B. aus Kunststoff versehen sein.

Das Modul 1 besteht aus einzelnen streifenförmigen Zellen C₁, C₂, ... Cₙ, Cₙ₊₁, die serienverschaltet sind. Dazu ist die Frontelektrodenschicht 3 durch Trennlinien 6, die Halbleiterschicht 4 durch Trennlinien 7 und die Rückelektrodenschicht 5 durch Trennlinien 8 unterbrochen, die senkrecht zur Stromflussrichtung F des Moduls 1 verlaufen.

Die optimale Breite der streifenförmigen Zellen C₁, C₂, ... Cₙ, Cₙ₊₁ wird durch den Flächenwiderstand der Frontelektrodenschicht 3 und der Rückelektrodenschicht 5 sowie der Impedanz der Zelle bei Beleuchtung bestimmt. Typischweise ergeben sich bei einem auf Leistung optimierten Modul je nach Dünnschichttechnologie Zellenbreiten von 4 bis 10 mm bei Dünnschicht-Einfachzellen, also Zellen mit nur einem p-n-Übergang beispielsweise mit einer Halbleiterschicht aus Silizium, während die Zellenbreite bei Siliziumdünnschicht-Stapelzellen, also Zellen mit mehreren p-n-Übergängen meist 7 bis 20 mm beträgt.

Die Rückelektrodenschicht 5 einer Zelle C₁, ... Cₙ kontaktiert damit durch die Trennlinien 7 in der Halbleiterschicht 4 hindurch die Frontelektrodenschicht 3 der benachbarten Zelle C₂, ... Cₙ₊₁. Der von dem photovoltaischen Modul erzeugte Strom wird mit den Kontakten 9, 10 an beiden Seiten des Moduls abgenommen, wobei der Kontakt 9 der Pluspol und der Kontakt 10 der Minuspol ist.

Die Trennlinien 6 in der Frontelektrodenschicht 3, die z.B. aus Zinnoxid gebildet ist, können mit dem fokussierten Laserstrahl eines (Nd:YAG)- oder ein (Nd:YVO₄) - Festkörperlaser mit einer Wellenlänge von 1064 nm gebildet werden, und die Trennlinien 7 in der Siliziumhalbleiterschicht 4 mit einem (Nd:YAG)- oder ein (Nd:YVO₄)-Festkörperlaser mit einer Wellenlänge von 532 nm.

Zur Bildung der Trennlinien 8 in der Rückelektrodenschicht 5, die beispielsweise aus einem Metall besteht, ist gemäß Figur 2a auf die Halbleiterschicht 4 eine wasserlösliche Ablösemasse 12 linienförmig aufgetragen worden, die dann z.B. durch Sputtern mit der Rückelektrodenschicht 5 beschichtet worden ist.

Durch den durch die Pfeile 13 dargestellten Wasserstrahl wird die Rückelektrodenschicht 5 auf der Ablösemasse 12 z.B. mechanisch beschädigt, wobei sich an den Beschädigungsstellen der Rückelektrodenschicht 5 die wasserlösliche Ablösemasse 12 auflöst und damit die Rückelektrodenschicht 5 an den auf der Ablösemasse 12 abgeschiedenen Stellen unter Bildung der Trennlinien 8 abgelöst und entfernt wird, wie in Figur 2b und Figur 1 dargestellt.

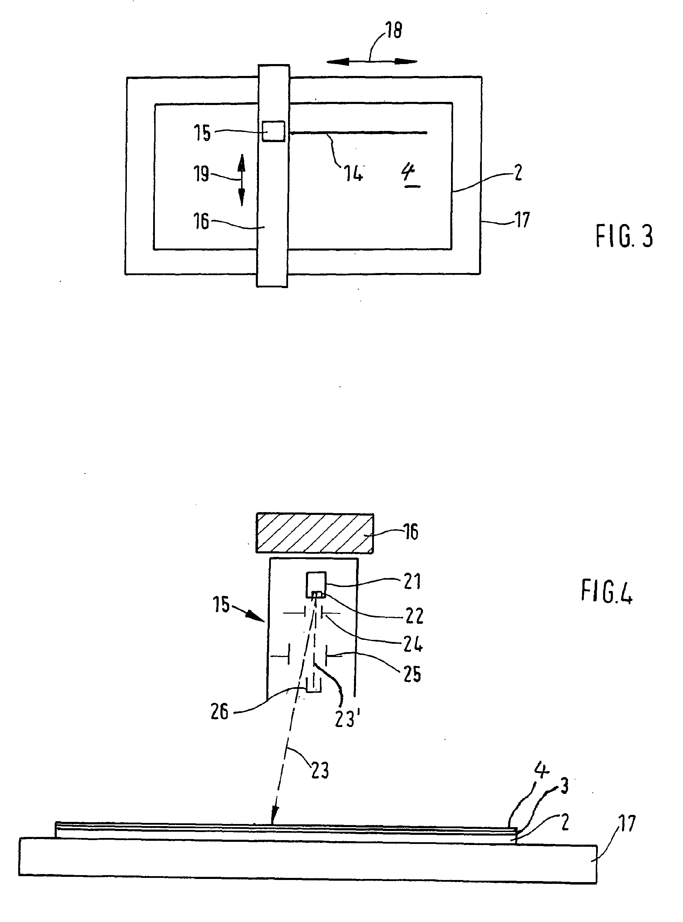

Die Ablösemasse 12 wird mit einem Tintenstrahldrucker 15 gemäß Figur 3 und 4 auf das mit der Frontelektrodenschicht 3 und der Halbleiterschicht 4 versehene Substrat 2 aufgetragen.

Dazu kann gemäß Figur 3 der Tintenstrahldrucker 15 an einem Träger 16 angeordnet sein, der entlang dem Tisch 17 in Richtung des Doppelpfeiles 18 verfahrbar ist. Der Tintenstrahldrucker 15 kann zudem entlang dem Träger 16 und damit quer zu dem Tisch 17 in Richtung des Doppelpfeiles 19 verfahren werden.

Damit kann durch Verfahren des Trägers 16 entsprechend dem Pfeil 18 in Figur 3 nach links bei einer bestimmten Position des Tintenstrahldruckers 15 gegenüber dem Träger 16 mit dem Tintenstrahldrucker 15 die Ablösemasse 12 auf der Halbleiterschicht 4 in den Trennlinien 8 entsprechenden Linien 14 aufgetragen werden.

Anschließend wird die Rückelektrodenschicht 5 aufgetragen und danach die Ablösemasse 12 mit der darüber liegenden Rückelektrodenschicht 5 durch Abspritzen des Moduls 1 mit dem Wasserstrahl 13 zur Bildung der Trennlinien 8 entfernt, wie vorstehend geschildert und in Figur 2a und 2b dargestellt.

Gemäß Figur 4 weist der Tintenstrahldrucker 15 einen piezoelektronischen Wandler 21 hinter der Düse 22 auf, der die von einem nicht dargestellten Vorratsbehälter zugeführte Ablösemasse-Lösung oder -dispersion als Tropfen mit einer Ladeelektrode 24 elektrostatisch auflädt, die anschließend mit einer Ablenkelektrode 25 seitlich auf die Halbleiterschicht 4 abgelenkt werden, wie durch den Strahl 23 veranschaulicht.

Der Tintenstrahldrucker 15 ist als kontinuierlicher Drucker ausgebildet, d.h. die Tropfen werden auch in den Pausen, beispielsweise für das Be- und Entladen der Substrate gebildet. Dazu können die Tropfen mit der Ablenkelektrode 25 einem Auffangbehälter 26 am Druckkopf des Tintenstrahldruckers 15 zugeführt werden, wie durch den Strahl 23' veranschaulicht, von wo sie in Kreislauf dem nicht dargestellten Vorratsbehälter zugeführt werden.

## Patentansprüche

1. Verfahren zur Herstellung eines photovoltaischen Moduls (1), bei dem auf ein transparentes Substrat (2) eine transparente Frontelektrodenschicht (3), eine Halbleiterschicht (4) und eine Rückelektrodenschicht (5) aufgebracht werden, welche zur Bildung serienverschalter Zellen (C₁, C₂, ... Cₙ, Cₙ₊₁) durch Trennlinien (6, 7, 8) strukturiert werden, wobei nach dem Aufbringen der Halbleiterschicht (4) auf die Bereiche der Halbleiterschicht (4), an denen die Trennlinien (8) in der Rückelektrodenschicht (5) gebildet werden sollen, eine Ablösemasse (12) in den Trennlinien (8) entsprechenden Linien (14) aufgetragen wird, worauf die Rückelektrodenschicht (5) aufgebracht und die Ablösemasse (12) mit den darauf aufgebrachten Bereichen der Rückelektrodenschicht (5) zur Bildung der Trennlinien (8) in der Rückelektrodenschicht (5) entfernt wird, **dadurch gekennzeichnet, dass** zur Bildung der Ablösemasse (12) eine Dispersion oder Lösung der Ablösemasse (12) mit einem Tintenstrahldrucker (15) auf die Halbleiterschicht (4) aufgetragen wird, die anschließend getrocknet wird, wobei als Tintenstrahldrucker (15) ein kontinuierlicher Tintenstrahldrucker (15) verwendet wird, sodass die Dispersion oder Lösung der Ablösemasse (12) aus dem Tintenstrahldrucker (15) auch in der Pause austritt, wenn nach dem Auftragen aller Linien (14) auf die Halbleiterschicht (4) ein Modul (1) entladen wird, um die Halbleiterschicht (4) eines neuen Moduls (4) mit den Ablösemasselinien (14) zu versehen.

2. Verfahren nach Anspruch 1, **dadurch gekennzeichnet, dass** mit dem Tintenstrahldrucker (15) eine wasserlösliche Ablösemasse (12) aufgetragen wird.

3. Verfahren nach Anspruch 2, **dadurch gekennzeichnet, dass** zur mechanischen Entfernung der Ablösemasse (12) und den darauf aufgebrachten Bereichen der Rückelektrodenschicht (5) ein Wasserstrahl (13) verwendet wird.

4. Verfahren nach einem der vorstehenden Ansprüche, **dadurch gekennzeichnet, dass** die Ablösemasse (12) nach dem Trocknen eine Schichtdicke von 0,1 bis 5 µm aufweist.
